# EUROPÄISCHE PATENTSCHRIFT

(11) **EP 1 384 394 B1**
(45) Veröffentlichungstag und Bekanntmachung des Hinweises auf die Patenterteilung: **16.06.2010**
(21) Anmeldenummer: 02740221.3
(22) Anmeldetag: 21.03.2002
(51) Int. Cl.: H05G 2/00

(54) **VERFAHREN ZUM ERZEUGEN VON EXTREM-ULTRAVIOLETTER STRAHLUNG ODER WEICHER RÖNTGENSTRAHLUNG**
METHOD FOR THE GENERATION OF FAR ULTRAVIOLET OR SOFT X-RAY RADIATION
PROCEDE DE PRODUCTION DE RAYONNEMENT ULTRAVIOLET EXTREME/RAYONNEMENT X MOU

(30) Priorität: 06.04.2001 DE 10117378; 12.07.2001 DE 10134033
(43) Veröffentlichungstag der Anmeldung: 28.01.2004
(73) Patentinhaber: Fraunhofer-Gesellschaft zur Förderung der angewandten Forschung e.V., 80686 München (DE); Philips Intellectual Property & Standards GmbH, 20099 Hamburg (DE); Koninklijke Philips Electronics N.V., 5621 BA Eindhoven (NL)
(72) Erfinder: NEFF, Willi, B-4721 Kelmis (BE); BERGMANN, Klaus, 52134 Herzogenrath (DE); ROSIER, Oliver, 41363 Jüchen (DE); PANKERT, Joseph, 52074 Aachen (DE)
(74) Vertreter: Gagel, Roland
(86) Internationale Anmeldenummer: PCT/DE2002/001017
(87) Internationale Veröffentlichungsnummer: WO 2002/082871

(56) Entgegenhaltungen:
- WO-A-01/01736
- US-A- 4 635 282
- US-B1- 6 188 076
- PATENT ABSTRACTS OF JAPAN vol. 011, no. 007 (E-469), 9. Januar 1987 (1987-01-09) & JP 61 183862 A (HITACHI LTD), 16. August 1986 (1986-08-16)

## Beschreibung

Die Erfindung bezieht sich auf ein Verfahren zum Erzeugen von Extrem-Ultraviolettstrahlung/weicher Röntgenstrahlung mit den Merkmalen des Oberbegriffs des Anspruchs 1.

Bevorzugte Anwendungsgebiete für die Extrem-Ultraviolette (EUV) Strahlung oder die weiche Röntgenstrahlung im Bereich von ca. 1 nm bis 20 nm Wellenlänge sind insbesondere die EUV-Lithographie. Aus der WO 99/29145 ist ein Verfahren mit den eingangs angesprochenen Merkmalen bekannt. Die bei diesem Verfahren eingesetzte Vorrichtung besteht aus einer Anode mit einer zentralen Bohrungsausnehmung und einer dieser gegenüberliegenden hohlen Kathode. Die Vorrichtung arbeitet in einer Umgebung konstanten Gasdrucks. Für die Erzeugung von EUV-Strahlung werden Gase mit Elementen der Atomnummer Z > 3 bevorzugt, zum Beispiel Xe mit breitbandiger Emissionscharakteristik. Wenn Hochspannung angewendet wird, gibt es einen Gasdurchbruch, der von dem Druck und dem Elektrodenabstand abhängt. Der Druck des Gases und der Elektrodenabstand sind so gewählt, daß das System auf dem linken Zweig der Paschen-Kurve arbeitet und infolgedessen kein dielektrischer Durchbruch zwischen den Elektroden auftritt. Nur in der Nachbarschaft der Hohlkathode sind die Feldlinien genügend gestreckt, so daß der Durchbruchbedingung oberhalb einer bestimm-ten Spannung entsprochen wird. Dann bildet sich ein stromführender Plasmakanal axialsymmetrischer Form entsprechend der Elektrodenausnehmung zwischen den Elektroden aus. Der mit der Vorrichtung verbundene elektrische Kreis ist so ausgebildet, daß ein sehr hoher Entladungsstrom auftritt, wenn der stromleitende Kanal aufgebaut wird. Dieser Strom baut um den Strompfad ein magnetisches Feld auf. Die resultierende Lorentz-Kraft schnürt das Plasma ein. Es ist seit langem bekannt, daß dieser Einschnürungseffekt das Plasma auf sehr hohe Temperaturen erhitzen und Strahlung sehr kurzer Wellenlänge erzeugen kann. Für die Vorrichtung ist nachgewiesen, daß sie EUV-Licht (10 bis 20 nm) sehr wirkungsvoll erzeugen kann, hohe Wiederholfrequenzen erlaubt und einen moderaten Elektrodenverschleiß hat.

Das im kurzwelligen Bereich emittierende Plasma entsteht entlang einer Symmetrieachse im Bereich der Hohlkathode bis über die Ausnehmung der Anode hinaus, je nach den vorhandenen Bedingungen. Relevante Parameter für eine Geometrie des Plasmas sind bedingt durch die Formen der Elektroden, wie Parameter eines angelegten elektrischen Stromes, wie dessen Dauer, dessen Form und dessen Amplitude, sowie die Gasdruckverhältnisse und die Zusammensetzung des Gases der Gasfüllung im Entladungsgefäß bzw. im Bereich der Elektroden.

Das bekannte Verfahren führt zu einem Pinch, also zu einem Plasmakanal, dessen Strahlung aus dem Elektrodensystem jedoch besser auskoppelbar sein sollte und der auch kürzer sein sollte.

Demzufolge liegt der Erfindung die Aufgabe zugrunde, ein Verfahren mit den eingangs genannten Merkmalen so zu verbessern, daß die Auskoppelbarkeit der Strahlung aus den Elektroden verbessert wird, und daß sich eine optimierte Plasmageometrie ergibt, nämlich ein axial kürzeres Emissionsgebiet.

Die vorstehende Aufgabe wird durch die Merkmale des Kennzeichenteils des Anspruchs 1 gelöst.

Für die Erfindung ist von Bedeutung, daß ein Druckgradient der Gasfüllung dazu benutzt wird, um den Pinch bzw. das Plasma zu verlagern und/oder zu verformen. Diese Maßnahmen führen zu einer Verbesserung der Auskoppelbarkeit der Strahlung aus den Elektroden, zum Beispiel in einen Kollektor einer EUV-Lithographie-Station. Die Verlagerung des Plasmas kann so durchgeführt werden, daß es optisch gut zugänglich ist, also möglichst wenig Abschattung erfolgt, auch nicht bei Betrachtung aus großen Beobachtungswinkeln, bezogen auf die Symmetrieachse. Auch kann eine optimale Anpassung des Lichtleitwerts der Strahlungsquelle, also des Plasmas, an das optische System erreicht werden. Der Lichtleitwert wird bestimmt durch das Produkt aus der effektiven Fläche des Plasmas und dem Öffnungswinkel. Grundsätzlich ist ein möglichst geringer Lichtleitwert anzustreben, also eine Punktquelle, so daß eine Nutzung eines möglichst großen Anteils des in einen Halbraum abgestrahlten Lichts gewährleistet ist. Bei der hier vorliegenden Quellgeometrie einer Elektrodenentladung reduziert sich das Problem im wesentlichen auf ein axial möglichst kurzes emittierendes Plasma, für das möglichst keine Strahlungsabschattungsverluste auftreten sollen.

Das Verfahren kann am Beispiel einer Anpassung der EUV-Lichtquelle an eine Optik einer EUV-Lithographie-Station näher beschrieben werden: Die EUV-Lichtquelle kann in einer Halbleiter-Lithographie-Einrichtung der nächsten Generation angewendet werden, für die eine Lichtquelle mit einer Hauptwellenlänge von etwa 13,5 nm erforderlich ist. Außer der Anforderung an die Wellenlängen gibt es jedoch strenge Anforderungen an das Lichtquellenformat des lichtemittierenden Bereichs und an die Gesamtleistung, die die Quelle zur Verfügung stellen muß. In beiden Hinsichten ist das bekannte Verfahren in seiner Leistung beschränkt. Zum einen, weil die Geometrie der Elektroden nur einen begrenzten Zugang zu dem lichtemittierenden Bereich erlaubt und der Rest des Lichts an die umgebenden Wände verschwendet wird. Zum Zweiten bildet eine axialsymmetrische Geometrie immer ein gestrecktes Plasma, das nicht wirkungsvoll konzentriert werden kann. Typische Längen sind zur Zeit 3 bis 10 mm, während die Sammeloptik lediglich Lichtquellenformate von etwa 2 mm und darunter verarbeiten kann.

Das Verfahren kann dahingehend modifiziert werden, daß eine der Elektroden als Hohlkathode ausgebildet wird, in der und/oder vor der in Bezug auf deren Umgebung ein Überdruck der Gasfüllung ausgebildet wird. Mit einer Hohlkathode kann Einfluß auf die Ausbildung des elektrischen Feldes genommen werden, das sich im Bereich der Elektrodenausnehmungen zwischen den Elektroden ausbildet. Mit dem Bohrlochbereich der Hohlkathode können die Feldlinien hinreichend gestreckt ausgebildet werden, um für eine vorbestimmte Spannung den Durchbruchsbedingungen zu genügen, so daß das System im Bereich des linken Zweigs der Paschen-Kurve arbeitet. Da die sich ausbildende elektrische Entladung außer von dem Elektrodenabstand und der Form der Elektroden auch vom Gasdruck der Gasfüllung abhängt, ist es vorteilhaft, vor der Elektrode im Bezug auf deren Umgebung einen Überdruck der Gasfüllung auszubilden. Der Überdruck hat zur Folge, daß sich die langen Feldlinien in Bereiche geringeren Gasdrucks erstrecken, so daß sich höhere Feldstärken für den elektrischen Durchbruch ergeben. Infolgedessen wird das sich im Falle eines Durchbruchs ausbildende Plasma als Folge des Druckgradienten verlagert. Die Verlagerung kann dabei in einen Bereich einer verbesserten Zugänglichkeit mit verringerter Abschattung erfolgen.

Es ist zu bevorzugen, wenn das Gas der Gasfüllung über die Hohlkathode eingelassen wird, von deren Elektrodenausnehmung ausgehend ein Druckgefälle aufgebaut wird. Ausgangspunkt des Druckgefälles und damit des angestrebten Druckgradienten ist infolgedessen der der Anode benachbarte Bereich der Elektrodenausnehmung der Hohlkathode. Entsprechend erfolgt eine Verlagerung des Plasmas von der Elektrodenausnehmung der Hohlkathode weg.

Eine weitere Verbesserung insbesondere der vorbeschriebenen Ausführungsform läßt sich dadurch erreichen, daß eine Düse verwendet wird, mit der Gas der Gasfüllung mit hoher Geschwindigkeit unter Verlagerung des Plasmas in das Entladungsgefäß geblasen wird. Bei dieser Ausführung ergibt sich ein zusätzlicher Steuerungsparameter, der die Formung der Isobarlinien vor der Elektrodenausnehmung der Kathode zu steuern erlaubt. Insbesondere ist es möglich, den Pinchbereich des Plasmas noch weiter auswärts zu verlagern, was Vorteile für die Kühlung der Einrichtung hat, mit der das Verfahren durchgeführt wird, insbesondere im Bereich der Elektroden.

Enfindungegemäß wird außer dem das Plasma ausbildenden Gas ein prozeßbeeinflussendes Füllgas in das Entladungsgefäß eingebracht. Mit dem Füllgas kann nicht nur eine Gradientenbildung bezüglich der Gasfüllung des Entladungsgefäßes erreicht werden, sondern es sind auch weitere Prozeßeinwirkungen möglich. Beispielsweise kann die Reabsorption von EUV-Strahlung durch das für die Gasentladung benutzte Primärgas minimiert werden. Dieses Problem ist besonders schwerwiegend, wenn Xenon als Entladungsgas benutzt wird, weil Xenon EUV-Strahlung stark reabsorbiert. Ein weiterer Vorteil kann sein, daß das Füllgas benutzt wird, die Entladung schneller zu löschen, als das Entladungsgas, um damit höhere Wiederholungsraten zu erreichen.

Besonders vorteilhafterweise wird so verfahren, daß das Füllgas rohrförmig um das das Plasma ausbildende Gas herum in das Entladungsgefäß hineinströmt. Mit Hilfe des Füllgases kann auf diese Weise eine sehr wirkungsvolle umfassende Formung des Entladungsgases erreicht werden.

Die Beschreibung bezieht sich auch auf eine Vorrichtung. Die Vorrichtung unterliegt den oben bezüglich des Verfahrens beschriebenen Nachteilen, so daß sich für die Vorrichtung eine der oben beschriebenen Aufgabe entsprechende Aufgabe ergibt. Diese Aufgabe wird durch die Merkmale des Kennzeichens des Anspruchs 1 gelöst.

Die Ausbildung eines höheren Gasdrucks nahe einer als Kathode ausgebildeten Elektrode in Bezug auf einen von dieser Elektrode entfernten Bereich führt zu einem entsprechende Druckgradienten und insbesondere zu einem Druckgefälle. Eine Folge dieses Druckgefälles ist eine Verlagerung des sich ausbildenden Plasmas im Sinne einer guten Zugänglichkeit bzw. einer verringerten optischen Abschattung bezüglich einer das Licht verarbeitenden Optik.

In Ausgestaltung der vorbeschriebenen Vorrichtung ist es zweckmäßig, diese so auszubilden, daß die Kathode als Hohlkathode ausgebildet ist, durch die das Gas der Gasfüllung in das Entladungsgefäß einbracht ist. Bei der Hohlkathode sind die oben beschriebenen gestreckten Feldlinien vorhanden, deren Ausbildung eine Voraussetzung ist, um zu annehmbaren Bedingungen für den linken Zweig der Paschen-Kurve kommen zu können. Zugleich wird durch die Hohlkathode das Gas der Gasfüllung in das Entladungsgefäß eingespeist, also das Entladungs- bzw. Primärgas. Hierdurch ergibt sich eine einfache konstruktive Ausgestaltung, da in diesem Fall des Einsatzes des Hohlraums der Hohlkathode zum Zwecke der Gaszuleitung eine besondere Ausbildung von einer Gaszuleitung dienenden Räumlichkeiten entfällt.

Die Düse kann in unterschiedlicher Weise eingesetzt werden. Vorteilhaft ist es, die Vorrichtung so auszubilden, daß die Elektrodenausnehmung und/oder die Mittelbohrung als Düse ausgebildet sind und/oder daß mit der Düse ein zur Hohlkathode gerichteter Gasfluß erzeugbar ist. Die vorbeschriebenen Ausgestaltungen können insbesondere auch in Kombination miteinander eingesetzt werden.

Eine weitere Spezifizierung der Vorrichtung kann dahingehend erfolgen, daß die Elektrodenausnehmung der Kathode eine die Einspeisegeschwindigkeit des das Plasma ausbildenden Gases und/oder die Gasverteilung beeinflussende Düse aufweist. Die Düse kann so ausgebildet werden, daß eine erhebliche Verlagerung des Plasmas in einen Bereich guter optischer Zugänglichkeit ermöglicht wird.

Des weiteren kann es von Vorteil sein, wenn die Kathode von der als Anode wirkenden Elektrode unter Bildung eines Ringraums mit Abstand umgeben ist, und daß die Elektrodenausnehmung der Anode konisch öffnend ausgebildet ist. In diesem Fall wird eine konzentrische Elektrodenanordnung ermöglicht, die sich durch eine besondere Freizügigkeit bezüglich der Zugänglichkeit des Raums auszeichnet, in die das Plasma verlagert wird. Die optische Zugänglichkeit kann weiter verbessert werden, wozu insbesondere die konische Öffnung der Elektrodenausnehmung der Anode beiträgt. Auch bei in Bezug auf die gemeinsame Elektrodenachse größeren Betrachtungswinkeln ergibt sich eine geringe Abschattung und im Falle eines kurzen Plasmas erscheint dieses auch bei größeren Betrachtungswinkeln eher dem Ideal einer Punktquelle angenähert.

Die Vorrichtung kann so ausgebildet werden, daß mittels des zwischen der Kathode und der Anode vorhandenen Ringraums ein Füllgas in das Entladungsgefäß einleitbar ist. Das Füllgas kann die Druckausbildung des Entladungsgases beeinflussen und mithin zu einer Verlagerung und einer Formung des Plasmas beitragen. Der zwischen der Kathode und der Anode vorhandene Ringraum führt zu einer entsprechend symmetrischen Ausbildung des mit Füllgas beschickten Bereichs des Entladungsgefäßes. Im Falle einer Rotationssymmetrie der Elektroden ist dieser Füllgasbereich entsprechend rotationssymmetrisch.

Wenn das Füllgas ein Extrem-Ultraviolettstrahlung reabsorbierendes Gas und/oder ein Plasma löschendes Gas ist, kann entsprechender Einfluß auf die Reabsorption von Extrem-Ultraviolettstrahlung und/oder auf die Wiederholfrequenzen genommen werden. Bei Pulsbetrieb ist mithin ein schnellerer Ablauf sich wiederholender Entladungsvorgänge möglich, was zu einer verbesserten Lichtausbeute führt.

Eine Minimierung des Verbrauchs von Entladungsgas ergibt sich, wenn die Vorrichtung so ausgebildet ist, daß das Entladungsgefäß außen im Bereich der Elektroden hauptsächlich mit Füllgas gefüllt ist.

Weiterhin kann es vorteilhaft sein, die Vorrichtung so auszubilden, das daß das Aspektverhältnis von Durchmesser zu Tiefe der Ausnehmung der Kathode kleiner als eins ist. Hierdurch wird nicht nur der Gasverbrauch minimiert und die Gasströmung ausgerichtet, so daß sich eine entsprechend große Verlagerung des Plasmas in Strömungsrichtung des Entladungsgases ergibt, sondern es wird auch dazu beigetragen, daß ein Stromtransport über die Wand der Ausnehmung der Kathode und die Wand der Hohlkathode und damit eine Schwächung des Plasmas möglichst unterdrückt wird.

Die Erfindung wird anhand der Zeichnung erläutert. Es zeigt:
- Fig. 1: ein Diagramm der Abhängigkeit der Zündspannung von dem Produkt aus Gasdruck und Elektrodenabstand,
- Fig.2: in schematischer Darstellung eine erste Elektrodenanordnung, und
- Fig.3: in schematischer Darstellung die Elektrodenanordnung der Fig.2 in abweichender Betriebsweise.

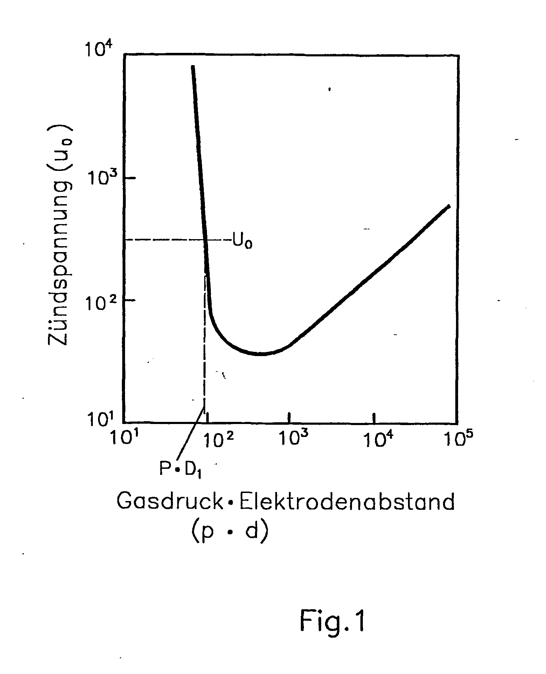

Fig. 1 veranschaulicht das Paschensche Gesetz, nämlich eine Abhängigkeit der für Gasentladungen maßgeblichen Zündspannung u₀ vom Produkt aus dem Gasdruck p und dem Elektrodenabstand d. Dabei ist U₀ diejenige Spannung, bei der eine selbständige Gasentladung in einer zwischen zwei Elektroden ausgebildeten Gasentladungsstrecke auftritt. Die Gesetzmäßigkeit gilt für eine bestimmte Elektrodengeometrie und ein bestimmtes Gas. Fig. 1 stellt klar, daß das strahlungserzeugende Verfahren entsprechend dem linken Ast der Paschen-Kurve durchgeführt werden soll, also mit einer Gasentladung, bei der die Erzeugung des Plasmas mehrstufig über Sekundärionisationsprozesse im Selbstdurchbruch erfolgt und die Plasmaverteilung bereits in der Startphase in hohem Maße zylindersymmetrisch ist. In das Plasma kann Energie eingekoppelt werden, nämlich mittels eines gepulsten Stromes, der von einer Stromquelle zur Verfügung gestellt werden muß. Durch geeignete Wahl der Amplitude und der Periodendauer der Strompulse kann die für die Lichtemission geeignete Temperatur des Plasmas eingestellt werden. Es kommt zu Periodendauern im zwei- bis dreistelligen Nanosekundenbereich. Während eines Pulses wird das Plasma infolge der sich aufbauenden Lorentz-Kraft eingeschnürt und es kommt zu einem sogenannten Pinch.

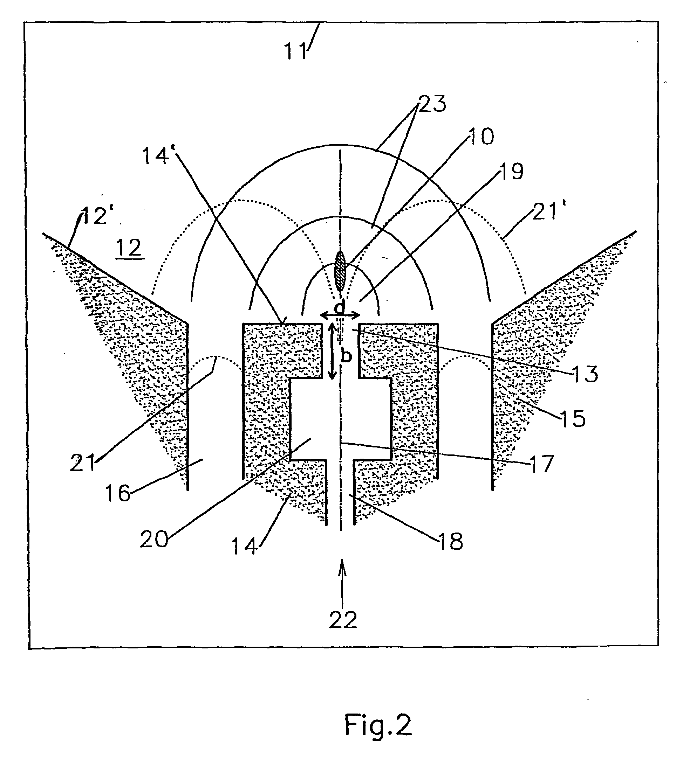

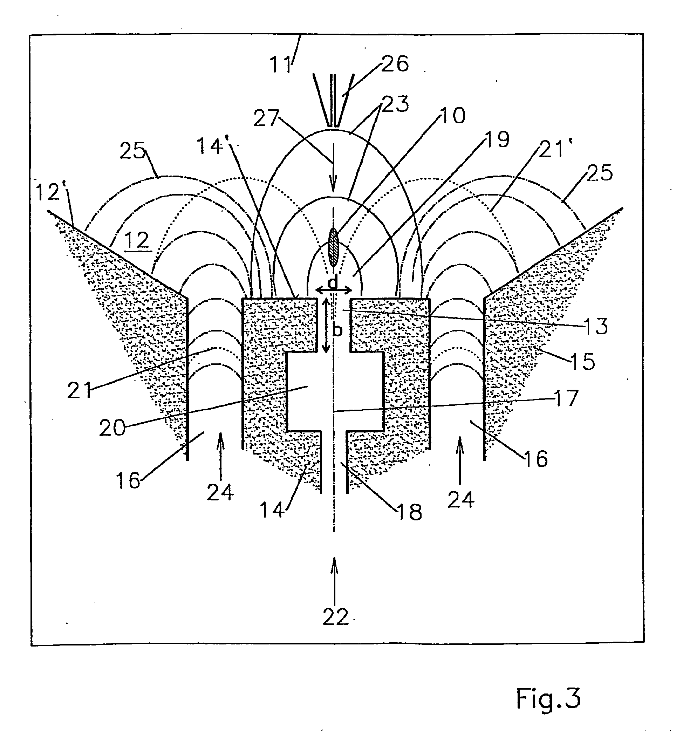

Die Fig.2,3 zeigen Pinchanordnungen schematisch dargestellter Elektroden. Die Elektroden sind im Bezug auf eine Symmetrieachse 17 rotationssymmetrisch ausgebildet. Die Anordnung der Elektroden ist konzentrisch. Dies Symmetrieachse 17 ist zugleich Mittelachse einer als Hohlkathode 14 ausgebildeten Elektrode. Die Hohlkathode 14 hat eine Mittelbohrung 18 mit einer Elektrodenausnehmung 13 in einem Mündungsbereich 19 der Mittelbohrung 18, wobei dieser Mündungsbereich 19 Bestandteil einer Elektrodenausnehmung 20 einer weiteren, als Anode 15 ausgebildeten Elektrode ist. Die Anode 15 ist ebenfalls rotationssymmetrisch und umgibt die Hohlkathode 14 mit einem Ringraum 16. Beide Elektroden sind in einem Entladungsgefäß 11 untergebracht, das mit Entladungsgas gefüllt ist, dessen Druck geringer ist, als der Atmosphärendruck.

Eine Besonderheit der Elektrodenausnehmung ist die Gestalt der Hohlkathode 14, die einen den Durchmesser der Mittelbohrung 18 erheblich erweiternden Hohlraum 20 in der Nähe der Elektrodenausnehmung 13 aufweist. Dadurch wird eine spezielle Ausbildung von Feldlinien 21 erreicht, von denen sich beispielsweise Feldlinien 21' bis in den Hohlraum 20 erstrecken und damit ein Feld aufbauen, das in guter Näherung parallel zur Symmetrieachse 17 verläuft. Wird die Spannung genügend gesteigert, so kommt es bei einem Erreichen der Zündspannung U₀ entweder zum Selbstdurchbruch, der zur Ausbildung eines Plasmas führt, oder es wird kurz vorher eine getriggerte Gasentladung erzeugt. Die Gasentladung bildet sich in der Nähe der Hohlkathode 14 vor deren Stirnwand 14' bzw. vor der Elektrodenausnehmung 13 aus, da hier die Konzentration des elektrischen Feldes am größten ist und die Feldstärke zur Anode 15 hin abnimmt, da sie eine sich konisch öffnende Elektrodenausnehmung 12 aufweist, bei der also die Ausnehmungswand 12' mit der Symmetrieachse 17 einen spitzen Winkel bis hin zu 90 Winkelgrad bildet. Die konische Ausnehmungswand 12' der Elektrodenausnehmung 12 ist dabei derart in Bezug auf die Hohlkathode 14 angeordnet, daß der kleinste Ausnehmungsdurchmesser der Anode 15, der gleich dem Außen- - durchmesser des zwischen den Elektroden vorhandenen Ringraums 16 ist, auf Höhe der Stirnwand 14' der Hohlkathode 14 angeordnet ist.

Die Mittelbohrung 18 ist als Gaseinlass 22 ausgebildet. Über den Gaseinlass 22 wird Entladungsgas durch die Mittelbohrung 18 in den Hohlraum 20 eingelassen und kann von dort aus durch die Elektrodenausnehmung 13 der Hohlkathode 14 in die Elektrodenausnehmung 12 der Anode strömen bzw. in das Entladungsgefäß, in dem ein Unterdruck aufrechterhalten wird. Der Druck des Entladungsgases kann bereits innerhalb der Hohlkathode 14 sinken. Jedenfalls aber von der Elektrodenausnehmung 13 an kann ein Druckgefälle aufgebaut werden. Die Fig.2 zeigt Isobaren 23 abnehmenden Drucks. Infolge der sich daraus ergebenden Druckgradienten der Gasfüllung wird das Plasma 10 in Richtung von der Kathode weg verlagert. Die Verlagerung erfolgt infolge der symmetrischen Ausbildung des elektrischen Feldes und der Gasdruckverteilung in Richtung der Symmetrieachse 17.

Das Ausmaß der Verlagerung des Plasmas 10 ist abhängig von den Abmessungen der Elektrodenausnehmung 13 und von der Strömungsgeschwindigkeit des Gases. Beispielsweise kann die Elektrodenausnehmung 13 als Düse ausgebildet sein, mit der Gas der Gasfüllung mit hoher Geschwindigkeit in das Entladungsgemäß 11 geblasen wird. Die Anordnung des Plasmas 10 in der Elektrodenausnehmung 12 kann in großem Ausmaß dadurch verändert werden, daß die geeigneten elektrischen und aerodynamischen Bedingungen gewählt werden. Insbesondere kann bei der beschriebenen Ausbildung der Anoden erreicht werden, daß das "Plasma 10 nicht mehr eine zylindrische Geometrie hat, sondern entsprechend der Darstellung auf ein geringeres, mehr eiförmiges Volumen konzentriert ist. Zugleich mit der Verlagerung erfolgt also auch eine in optischer Hinsicht vorteilhafte Verformung des Plasmas 10.

Die vorstehenden Ausführungen gelten auch für die Ausführungsform der Fig.3. Hier ist die Besonderheit dargestellt, daß der zwischen den Elektroden vorhandene Ringraum 16 als Gaseinlaß 24 genutzt wird. Es wird beispielsweise ein Füllgas 25 benutzt, das infolge der ringförmigen bzw. rohrförmigen Ausbildung des Ringraums 16 entsprechend rohrförmig um das das Plasma 10 ausbildende Gas herum in das Entladungsgefäß 11 strömt. Dieses Füllgas 25 hat eine formgebende Einwirkung auf das das Plasma ausbildende Gas. Fig.3 zeigt im Vergleich zu Fig. 2 die einengende Wirkung von strichpunktiert dargestelltem Füllgas 25 auf das das Plasma erzeugende Gas und damit auf dessen Isobaren 23. Auch mit Hilfe des Füllgases kann also im plasmaerzeugenden Gas für Druckänderungen gesorgt werden, die wiederum zu Verlagerungen und/oder Verformungen des Plasmas 10 führen.

In Fig.3 ist eine Düse 26 dargestellt, mit der Gaseinlaß eines Entladungsgases an den Vorderseiten der Elektroden realisiert ist. Die Austrittsgeschwindigkeit des Gases muß hoch genug sein, um einen gemäß dem Pfeil 27 zur Hohlkathode 14 gerichteten Gasfluß zu erzeugen. Mit diesem wird vor der Stirnwand 14' der Hohlkathode 14 ein höherer Druck erzeugt, der zum Hintergrund entsprechend den Isobaren 23 abnehmenden Drucks stark abfällt.

Die vorbeschriebene Ausbildung der Elektroden zur Pinchformung über inhomogene Druckverhältnisse des im Entladungsgefäß 11 befindlichen Gases, insbesondere des vor der Stirnwand 14' der Hohlkathode befindlichen Gases, kann durch vorbestimmte Bemessungen der Elektrodenausnehmung 13 ergänzt werden. Insbesondere ist es von Vorteil, die Elektrodenausnehmung 13 als Kathodenöffnung so auszubilden, daß das Aspektverhältnis von Durchmesser d zu Tiefe b < 1 ist. Das führt nicht nur zur Vergleichmäßigung der Strömung des Gases, wenn dieses durch die Elektrodenausnehmung 13 in das Entladungsgefäß 11 gespeist wird, sondern es läßt sich auch der Transport von für das Plasma bestimmten Ladungsträgern beeinflussen. Insbesondere wird der Stromtransport über die Elektrodenausnehmung 13 und über die den Hohlraum 20 bildende Wand der Hohlkathode 14 weitgehend unterdrückt. Auch das befördert die Ausbildung des Plasmas 10 in einen Bereich der Elektrodenausnehmung 12, in dem eine optisch gute Zugänglichkeit gegeben ist, also ohne Abschattung des Plasmas, auch bei größeren Beobachtungswinkeln zur Symmetrieachse 18.

## Patentansprüche

1. Verfahren zum Erzeugen von Extrem-Ultraviolettstrahlung/weicher Röntgenstrahlung mittels einer Gasentladung, insbesondere für die EUV-Lithographie, bei dem in einem Entladungsgefäß (11) zwei Elektroden an Hochspannung gelegt werden, zwischen denen in einem Bereich zweier gleichachsiger Elektrodenausnehmungen (12, 13) eine Gasfüllung mit vorbestimmtem Gasdruck entsprechend eines auf dem linken Zweig der Paschen-Kurve erfolgenden Entladungsbetriebs bereitgestellt wird, in der ein die Strahlung abgebendes Plasma (10) unter Energiezufuhr ausgebildet wird,
**dadurch gekennzeichnet,**
**dass** eine Position und/oder Form des Plasmas (10) im Bereich der Elektrodenausnehmungen (12,13) mittels eines Druckgradienten der Gasfüllung festgelegt wird und
**dass** außer dem das Plasma ausbildenden Gas ein prozessbeeinflussendes Füllgas (25) in das Entladungsgefäß (11) eingebracht wird.

2. Verfahren nach Anspruch 1,
**dadurch gekennzeichnet,**
**dass** eine der Elektroden als Hohlkathode (14) ausgebildet wird, in der und/oder vor der in Bezug auf deren Umgebung ein Überdruck der Gasfüllung ausgebildet wird.

3. Verfahren nach Anspruch 2,
**dadurch gekennzeichnet,**
**dass** das Gas der Gasfüllung über die Hohlkathode (14) eingelassen wird, von deren Elektrodenausnehmung (13) ausgehend ein Druckgefälle aufgebaut wird.

4. Verfahren nach einem der Ansprüche 1 bis 3,
**dadurch gekennzeichnet,**
**dass** eine Düse (26) verwendet wird, mit der Gas der Gasfüllung unter Verlagerung des Plasmas (10) in das Entladungsgefäß (11) geblasen wird.

5. Verfahren nach einem der Ansprüche 1 bis 4,
**dadurch gekennzeichnet,**
**dass** das Füllgas (25) rohrförmig um das das Plasma (10) ausbildende Gas herum in das Entladungsgefäß (11) hineinströmt.

6. Verfahren nach einem der Ansprüche 1 bis 5,
**dadurch gekennzeichnet,**
**dass** als Füllgas (25) ein Extrem-UltraviolettStrahlung reabsorbierendes Gas und/oder ein Plasma (10) löschendes Gas eingesetzt wird.

7. Verfahren nach einem der Ansprüche 1 bis 6,
**dadurch gekennzeichnet,**
**dass** das Entladungsgefäß außen im Bereich der Elektroden hauptsächlich mit Füllgas (25) gefüllt wird.

8. Verfahren nach einem der Ansprüche 1 bis 7,
**dadurch gekennzeichnet,**
**dass** ein Aspektverhältnis von Durchmesser (d) zu Tiefe (b) der Elektrodenausnehmung (13) der als Kathode genutzten Elektrode kleiner als eins gewählt wird.

## Claims

1. A method for generating extreme ultraviolet radiation/soft x-ray radiation using a gas discharge, in particular for EUV lithography, in which high voltage is applied to two electrodes in a discharge vessel (11), between which a gas filling having predetermined gas pressure corresponding to a discharge operation occurring on the left branch of the Paschen curve is provided in an area of two coaxial electrode recesses (12, 13), in which a plasma (10), which discharges the radiation, is formed with energy supply,
**characterized in that**
a position and/or shape of the plasma (10) in the area of the electrode recesses (12, 13) is established using a pressure gradient of the gas filling and,
in addition to the gas forming the plasma, a process-influencing filling gas (25) is introduced into the discharge vessel (11).

2. The method according to Claim 1,
**characterized in that**
one of the electrodes is implemented as a hollow cathode (14), in which and/or in front of which an overpressure of the gas filling is implemented in relation to its surroundings.

3. The method according to Claim 2,
**characterized in that**
the gas of the gas filling is introduced via the hollow cathode (14), from which a pressure gradient is built up starting from its electrode recess (13).

4. The method according to one of Claims 1 through 3,
**characterized in that**
a nozzle (26) is used, using which the gas of the gas filling is blown into the discharge vessel (11) with displacement of the plasma (10).

5. The method according to one of Claims 1 through 4,
**characterized in that**
the filling gas (25) flows into the discharge vessel (11) in a tubular shape around the gas forming the plasma (10).

6. The method according to one of Claims 1 through 5,
**characterized in that**
a gas which reabsorbs extreme ultraviolet radiation and/or a gas which extinguishes plasma (10) is used as the filling gas (25).

7. The method according to one of Claims 1 through 6,
**characterized in that**
the discharge vessel is primarily filled with filling gas (25) except in the area of the electrodes.

8. The method according to one of Claims 1 through 7,
**characterized in that**
an aspect ratio of diameter (d) to depth (b) of the electrode recess (13) of the electrode used as the cathode of less than one is selected.

## Revendications

1. Procédé de génération d'un rayonnement ultraviolet extrême/rayonnement radiographique modéré au moyen d'une décharge gazeuse, notamment pour la lithographie UVE, dans lequel, dans une cuve de décharge (11), sont posées sous haute tension deux électrodes entre lesquelles, dans le secteur de deux cavités d'électrodes (12, 13) ayant le même axe, est réalisé un remplissage au gaz avec une pression de gaz prédéfinie en fonction d'une opération de décharge ayant lieu sur la branche gauche de la courbe de Paschen et dans lequel un plasma (10) émettant le rayonnement est constitué sous apport énergétique,
**caractérisé en ce que**
une position et/ou forme du plasma (10) est établie au niveau des cavités d'électrodes (12, 13) au moyen d'un gradient de pression du remplissage de gaz et que,
en dehors du gaz de remplissage (25) constituant le plasma, un gaz influant sur le processus est introduit dans la cuve de décharge (11).

2. Procédé selon la revendication 1,
**caractérisé en ce que**
une des électrodes se présente sous la forme d'une cathode creuse (14) dans laquelle/en amont de laquelle, en fonction de son environnement, une surpression du remplissage de gaz est créée.

3. Procédé selon la revendication 2,
**caractérisé en ce que**
le gaz du remplissage de gaz rentre par la cathode creuse (14) depuis la cavité d'électrode (13) de laquelle une chute de pression est créée.

4. Procédé selon une des revendications 1 à 3,
**caractérisé en ce que**
on utilise une buse (26) à l'aide de laquelle le gaz du remplissage de gaz est soufflé dans la cuve de décharge (11) en déplaçant le plasma (10).

5. Procédé selon une des revendications 1 à 4,
**caractérisé en ce que**
le gaz de remplissage (25) afflue sous forme tubulaire autour du gaz constituant le plasma (10) dans la cuve de décharge (11).

6. Procédé selon une des revendications 1 à 5,
**caractérisé en ce que**
on utilise comme gaz de remplissage (25) un gaz réabsorbant le rayonnement ultraviolet extrême et/ou un gaz (10) éteignant le plasma.

7. Procédé selon une des revendications 1 à 6,
**caractérisé en ce que**
la cuve de décharge sauf dans le domaine des électrodes est remplie principalement de gaz de remplissage (25).

8. Procédé selon une des revendications 1 à 7,
**caractérisé en ce que**
un rapport d'aspect entre le diamètre (d) et la profondeur (b) du creux d'électrode (13) de l'électrode utilisée comme cathode est défini à un niveau inférieur à un.
